(19) Europäisches Patentamt / European Patent Office / Office européen des brevets

(11) **EP 3 605 623 B1**

(12) **EUROPEAN PATENT SPECIFICATION**

(45) Date of publication and mention
of the grant of the patent:
**15.06.2022 Bulletin 2022/24**

(21) Application number: **19152576.5**

(22) Date of filing: **18.01.2019**

(51) International Patent Classification (IPC):
*H01L 33/58* (2010.01)    *H01L 33/50* (2010.01)
*H01L 25/075* (2006.01)    *H01L 25/16* (2006.01)

(52) Cooperative Patent Classification (CPC):
**H01L 33/58;** H01L 25/0753; H01L 25/167;
H01L 33/505

(54) **LIGHT-EMITTING DEVICE**

LICHTEMITTIERENDE VORRICHTUNG

DISPOSITIF ÉLECTROLUMINESCENT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **31.07.2018 US 201816050120**

(43) Date of publication of application:
**05.02.2020 Bulletin 2020/06**

(73) Proprietor: **InnoLux Corporation
Chu-Nan, Miao-Li 350 (TW)**

(72) Inventors:
• **CHEN, Jia-Yuan
350 Miao-Li County (TW)**
• **TSAI, Tsung-Han
350 Miao-Li County (TW)**
• **LEE, Kuan-Feng
350 Miao-Li County (TW)**
• **YUEH, Jui-Jen
350 Miao-Li County (TW)**

(74) Representative: **2K Patentanwälte Blasberg
Kewitz & Reichel
Partnerschaft mbB
Schumannstrasse 27
60325 Frankfurt am Main (DE)**

(56) References cited:
WO-A1-2008/018615    DE-B3-102016 106 841
US-A1- 2017 358 604

## Description

## BACKGROUND

### Field of the Disclosure

The embodiments of the disclosure relate to a light-emitting device, and in particular to a light-emitting device with light-emitting diodes.

### Description of the Related Art

As digital technology develops, light-emitting devices are becoming more widely used in our society. For example, light-emitting devices have been applied in modern information and communication devices such as televisions, notebooks, computers, mobile phones and smartphones. In addition, each generation of light-emitting devices has been developed to be thinner, lighter, smaller, and more fashionable. These light-emitting devices include light-emitting diode light-emitting devices.

The recombination of electron and hole in the light-emitting diode may produce electromagnetic radiation (such as light) through the current at the p-n junction. For example, in the forward bias p-n junction formed by direct band gap materials such as GaAs or GaN, the recombination of electron and hole injected into the depletion region results in electromagnetic radiation. The aforementioned electromagnetic radiation may lie in the visible region or the non-visible region. Materials with different band gaps may be used to form light-emitting diodes of different colors.

DE 10 2016 / 106841 B3 discloses a converter assembly for converting a primary light into a secondary light, comprising at least one element which has a light-converting structure with open pores and which is laterally held by a frame. The surfaces of both the light-converting structure as well as of the inner face of the frame are covered with a transparent layer such that each of the aforementioned elements forms an areal in which a property of the incident light and preferably of the wavelength thereof is changed. In specific embodiments, the converter assembly can be part of display assemblies or of miniaturized components for example. The invention also relates to a method for producing the converter assembly.

US 2017/358604 A1 discloses a display apparatus including an array substrate, a light emitting element, and a light shielding layer. The light emitting element is disposed on the array substrate and includes a first upper surface. The light shielding layer is disposed on a periphery of the light emitting element and includes a second upper surface. A distance between the first upper surface and the second upper surface in a direction perpendicular to the array substrate is between 0 and 5 μm.

WO2008/018615 A1 (see Fig. 1) discloses a light-emitting device (1) having a base (10) and a light-emitting element (11) placed on the base (10) includes a first sealing material layer (12) covering the light-emitting element (11) and a second sealing material layer (13) surrounding a side surface of the first sealing material layer (12), wherein the refractive index of the first sealing material layer (12) and the refractive index of the second sealing material layer (13) are different from each other. The light-emitting device (1) is capable of controlling a radiation pattern from the light-emitting element (11) by controlling the refractive index of the first sealing material layer (12) and the refractive index of the second sealing material layer (13). This can facilitate the miniaturization and reduction in thickness of the light-emitting device (1), and prevent the decrease in a light output efficiency of the light-emitting device (1).

Since mass production has become the tendency recently in the light-emitting diode industry, any increase in the yield of manufacturing light-emitting diodes will reduce costs and result in huge economic benefits. However, existing light-emitting devices have not been satisfactory in every respect.

Therefore, a light-emitting diode which may further increase the production yield and a light-emitting device which is manufactured from the light-emitting diode are needed.

## SUMMARY

A light-emitting device is provided. The light-emitting device includes a light-emitting element. The light-emitting device also includes a wavelength conversion element disposed on the light-emitting element. The wavelength conversion element has a first refractive index in a first wavelength. The light-emitting device further includes a light blocking element surrounding the wavelength conversion element. The light blocking element has a second refractive index in the first wavelength. The second refractive index is greater than the first refractive index. According to the invention, the light blocking element comprises a photoresist element and a capping layer covering the photoresist element. Preferably, the capping layer comprises silicon.

A detailed description is given in the following embodiments with reference to the accompanying drawings.

## BRIEF DESCRIPTION OF THE DRAWINGS

The disclosure may be more fully understood by reading the subsequent detailed description and examples with references made to the accompanying drawings, wherein:

Figs. 1A-1G are cross-sectional views of various stages of a process for forming a light-emitting device in accordance with some embodiments of the present disclosure which are not according to the claimed invention;

Figs. 2A-2D are cross-sectional views of various stages of a process for forming a structure containing light conversion elements and light blocking elements in accordance with some embodiments of the present disclosure which are not according to the claimed invention;

Figs. 3A-3D are cross-sectional views of various stages of a process for forming a structure containing light conversion elements and light blocking elements in accordance with the claimed invention;

Fig. 4 is a cross-sectional view of a light-emitting device in accordance with the claimed invention;

Fig. 5 is a cross-sectional view of a structure containing light conversion elements and light blocking elements in accordance with some embodiments of the present disclosure which are not according to the claimed invention;

Figs. 6A and 6B are cross-sectional views of various stages of a process for forming a light-emitting device in accordance with some embodiments of the present disclosure which are not according to the claimed invention;

Fig. 7 is a cross-sectional view of a structure containing light conversion elements and light blocking elements in accordance with the claimed invention;

Fig. 8 is a cross-sectional view of a light-emitting device in accordance with some embodiments of the present disclosure which are not according to the claimed invention;

Fig. 9 is a cross-sectional view of a light-emitting device in accordance with some embodiments of the present disclosure which are not according to the claimed invention;

Fig. 10 is a cross-sectional view of a light-emitting device in accordance with some embodiments of the present disclosure which are not according to the claimed invention;

Fig. 11 is a cross-sectional view of a light-emitting device in accordance with some embodiments of the present disclosure which are not according to the claimed invention;

Fig. 12 is a cross-sectional view of a light-emitting device in accordance with some embodiments of the present disclosure which are not according to the claimed invention;

DETAILED DESCRIPTION OF THE DISCLOSURE

The light-emitting device of the present disclosure is described in detail in the following description. In the following detailed description, for purposes of explanation, numerous specific details and embodiments are set forth in order to provide a thorough understanding of the present disclosure. The specific elements and configurations described in the following detailed description are set forth in order to clearly describe the present disclosure. It will be apparent, however, that the exemplary embodiments set forth herein are used merely for the purpose of illustration, and the inventive concept may be embodied in various forms without being limited to those exemplary embodiments. In addition, the drawings of different embodiments may use like and/or corresponding numerals to denote like and/or corresponding elements in order to clearly describe the present disclosure. However, the use of like and/or corresponding numerals in the drawings of different embodiments does not suggest any correlation between different embodiments. In addition, in this specification, expressions such as "first material layer disposed on/over a second material layer", may indicate the direct contact of the first material layer and the second material layer, or it may indicate a non-contact state with one or more intermediate layers between the first material layer and the second material layer. In the above situation, the first material layer may not be in direct contact with the second material layer.

It should be noted that the elements or devices in the drawings of the present disclosure may be present in any form or configuration known to those skilled in the art. In addition, the expression "a layer overlying another layer", "a layer is disposed above another layer", "a layer is disposed on another layer" and "a layer is disposed over another layer" may indicate that the layer is in direct contact with the other layer, or that the layer is not in direct contact with the other layer, there being one or more intermediate layers disposed between the layer and the other layer.

In addition, in this specification, relative expressions are used. For example, "lower", "bottom", "higher" or "top" are used to describe the position of one element relative to another. It should be appreciated that if a device is flipped upside down, an element that is "lower" will become an element that is "higher".

The terms "about" and "substantially" typically mean +/- 20% of the stated value, more typically +/- 10% of the stated value, more typically +/- 5% of the stated value, more typically +/- 3% of the stated value, more typically +/- 2% of the stated value, more typically +/- 1% of the stated value and even more typically +/- 0.5% of the stated value. The stated value of the present disclosure is an approximate value. When there is no specific description, the stated value includes the meaning of "about" or "substantially".

It should be understood that, although the terms first, second, third etc. may be used herein to describe various elements, components, regions, layers, portions and/or sections, these elements, components, regions, layers, portions and/or sections should not be limited by these terms. These terms are only used to distinguish one element, component, region, layer, portion or section from another region, layer or section. Thus, a first element, component, region, layer, portion or section discussed below could be termed a second element, component, region, layer, portion or section without departing from the teachings of the present disclosure.

Unless defined otherwise, all technical and scientific terms used herein have the same meaning as commonly understood by one of ordinary skill in the art to which this disclosure belongs. It should be appreciated that, in each case, the term, which is defined in a commonly used dictionary, should be interpreted as having a meaning that conforms to the relative skills of the present disclosure and the background or the context of the present disclosure, and should not be interpreted in an idealized or overly formal manner unless so defined.

This description of the exemplary embodiments is intended to be read in connection with the accompanying drawings, which are to be considered part of the entire written description. The drawings are not drawn to scale. In addition, structures and devices are shown schematically in order to simplify the drawing.

In the description, relative terms such as "lower," "upper," "horizontal," "vertical,", "above," "below," "up," "down," "top" and "bottom" as well as derivative thereof (e.g., "horizontally," "downwardly," "upwardly," etc.) should be construed to refer to the orientation as then described or as shown in the drawing under discussion. These relative terms are for convenience of description and do not require that the apparatus be constructed or operated in a particular orientation. Terms concerning attachments, coupling and the like, such as "connected" and "interconnected," refer to a relationship wherein structures are secured or attached to one another either directly or indirectly through intervening structures, as well as both movable or rigid attachments or relationships, unless expressly described otherwise.

The term "substrate" is meant to include devices formed within a transparent substrate and the layers overlying the transparent substrate. All transistor element needed may be already formed over the substrate. However, the substrate is represented with a flat surface in order to simplify the drawing. The term "substrate surface" is meant to include the uppermost exposed layers on a transparent substrate, such as an insulating layer and/or metallurgy lines.

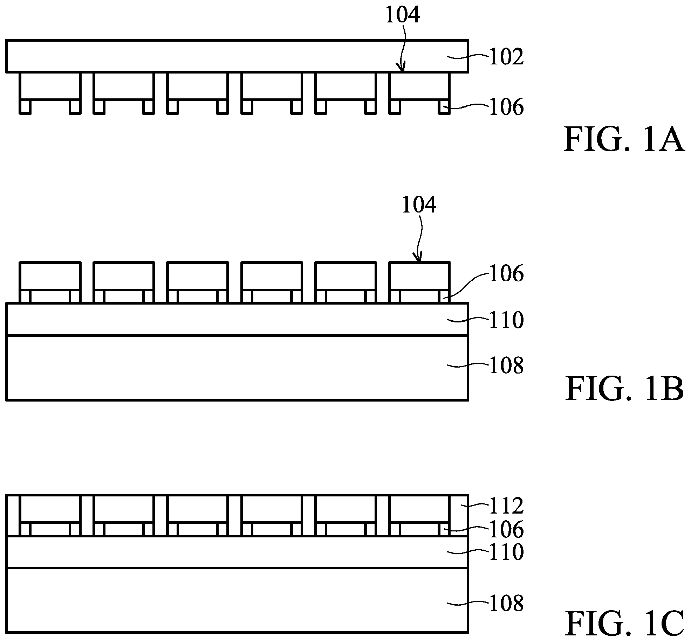

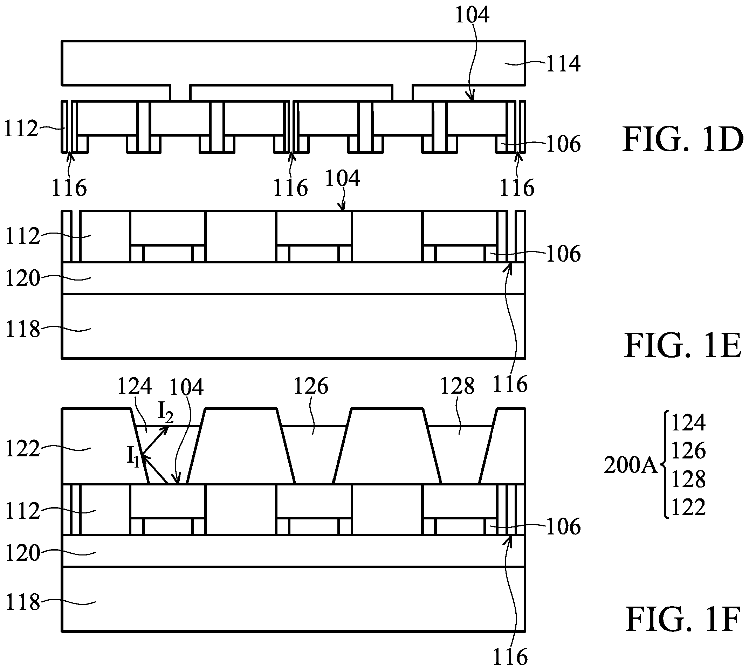

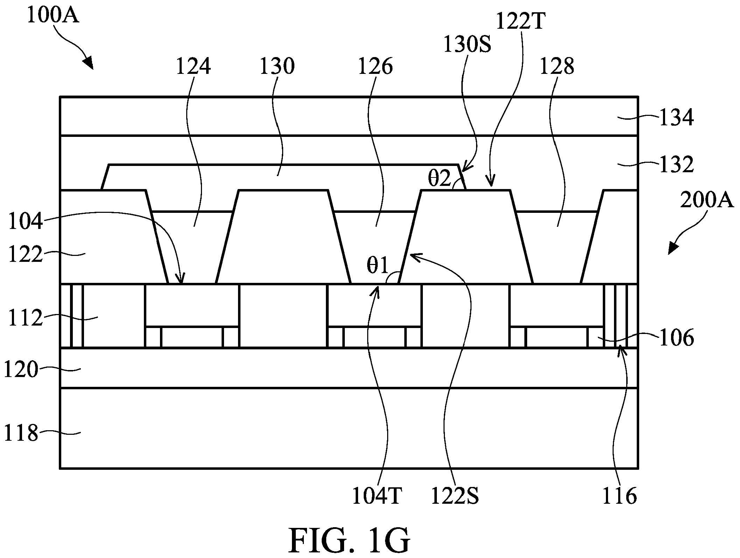

Figs. 1A-1G are cross-sectional views of various stages of a process for forming a light-emitting device 100A in accordance with some embodiments of the present disclosure which are not according to the claimed invention. In some embodiments, as shown in Fig. 1, a plurality of light-emitting elements 104 are formed over a growth substrate 102. In some embodiments, the growth substrate 102 is a wafer substrate which includes silicon or a sapphire substrate which includes alumina oxide. In other embodiments, the growth substrate 102 is a substrate including GaP, GaAs, AlGaAs or SiC.

In some embodiments, the light-emitting element 104 is for example a micro light-emitting diode ($\mu$LED). The size of the chip of the $\mu$LED is in a range of about 1$\mu$m to about 100$\mu$m. The light-emitting element 104 can be a mini light-emitting diode. The size of the chip of the mini LED is in a range of about 100$\mu$m to about 300$\mu$m. The light-emitting element 104 can be a light-emitting diode. The size of the chip of the LED is in a range of about 300$\mu$m to about 10mm. The recombination of electron and hole in the $\mu$LED may produce electromagnetic radiation (such as light) through the current at the p-n junction. For example, in the forward bias p-n junction formed by direct band gap materials such as GaAs or GaN, the recombination of electron and hole injected into the depletion region results in electromagnetic radiation. The aforementioned electromagnetic radiation may lie in the visible region or the non-visible region. Materials with different band gaps may be used to form light-emitting diodes of different colors.

In some embodiments, the light-emitting element 104 includes a p-type semiconductor layer, an n-type semiconductor layer and a light-emitting layer disposed between them. The p-type semiconductor layer may provide holes, and the n-type semiconductor layer may provide electrons. As a result, the holes and the electrons recombine to generate electromagnetic radiation. The semiconductor layers may include, but are not limited to, AlN, GaN, GaAs, InN, AlGaN, AlInN, InGaN, AlInGaN or a combination thereof.

The light-emitting layer may include, but is not limited to, homojunction, heterojunction, single-quantum well (SQW), multiple-quantum well (MQW) or any other applicable structure. In some embodiments, the light-emitting layer includes un-doped n type $In_xGa_{(1-x)}N$. In other embodiments, the light-emitting layer includes such materials as $Al_xIn_yGa_{(1-x-y)}N$ and other materials. Moreover, the light-emitting layer may include a multiple-quantum well structure with multiple-quantum layers (such as InGaN) and barrier layers (such as GaN) arranged alternately. Moreover, the light-emitting layer may be formed by metalorganic chemical vapor deposition (MOCVD), molecular beam epitaxy (MBE), hydride vapor phase epitaxy (HVPE), liquid phase epitaxy (LPE) or any other applicable chemical vapor deposition process.

As shown in Fig. 1A, conductive pads 106 are formed on surfaces of the light-emitting elements 104. The conductive pads 106 are configured to electrically connect the light-emitting elements 104 and other conductive elements. The material of the conductive pad 106 may include, but is not limited to, copper (Cu), aluminum (Al), molybdenum (Mo), tungsten (W), gold (Au), chromium (Cr), nickel (Ni), platinum (Pt), titanium (Ti), iridium (Ir), Rhodium (Rh), an alloy of the above, a combination of the above, or any other applicable material.

As shown in Fig. 1B, the light-emitting elements 104 are attached to a carrier substrate 108, and the growth substrate 102 is removed from the light-emitting elements 104 in accordance with some embodiments. In some embodiments, the light-emitting elements 104 are attached to the carrier substrate 108 through the conductive pads 106 and an adhesive layer 110. In some embodiments, the carrier substrate 108 is a substrate that the light-emitting elements 104 put on temporarily. In the subsequent processes, the light-emitting elements 104 are removed from the carrier substrate 108. The carrier substrate 108 may include a glass substrate, a ceramic substrate, a plastic substrate or another applicable substrate. The material of the adhesive layer 110 can be a polymer or another applicable material. In some embodiments, the light-emitting elements 104 are transferred to the carrier substrate 108 from the growth substrate 102 by a laser lift off (LLO) process.

As shown in Fig. 1C, a supporting structure 112 is formed to surround the light-emitting elements 104 and the conductive pads 106 in accordance with some embodiments. The supporting structure 112 is configured to protect the light-emitting elements 104 and the conductive pads 106 from damage or pollution in subsequent processes. The material of the supporting structure 112 may comprise, but is not limited to, resin or another applicable material. In some embodiments, the supporting structure 112 is made of black resin. The supporting structure 112 may be formed by a coating process. In some embodiments, a resin material is coated to fill the space between two adjacent light-emitting elements 104 and cover top surfaces of the light-emitting elements 104. Next, a patterning process is performed to remove a portion of the resin material to expose the top surfaces of the light-emitting elements 104.

As shown in Fig. 1D, the light-emitting elements 104, the conductive pads 106 and the supporting structure 112 are transferred to a transfer head 114 in accordance with some embodiments. The transfer head 114 is used to pick up the light-emitting elements 104 and put them on other substrate. In some embodiments, the transfer head 114 may be disposed on a microelectromechanical system (MEMS) device (not shown). In some embodiments, the light-emitting elements 104 are transferred to the transfer head 114 by a vacuum suction force or a static electricity force. In addition, scribe lines 116 are formed during the transferring process is performed. The scribe line 116 is formed by cutting the supporting structure 112. Fig. 1D illustrates that three light-emitting elements 104 constitute a group and these light-emitting elements 104 are between two adjacent scribe lines 116. The amounts of the light-emitting elements 104 of the group can be adjusted, and the scope of disclosure is not intended to be limiting.

As shown in Fig. IE, the light-emitting elements 104 are transferred to a substrate 118 from the transfer head 114, in accordance with some embodiments. In order to clearly illustrate the relation between various elements, Fig. 1E and following figures only illustrate the positional relation between one group consisted of three light-emitting elements 104 and other elements. In some embodiments, the substrate 118 may include a transparent or nontransparent substrate such as a glass substrate, a ceramic substrate, a plastic substrate or another applicable substrate. As shown in Fig. IE, a circuit layer 120 is formed on the substrate 118. The substrate 118 may be a carrier substrate. The circuit layer 120 may include a dielectric layer (not shown) and a plurality of conductive elements (not shown) formed therein. The dielectric layer may include, but is not limited to, silicon oxide, silicon nitride, silicon oxynitride or another applicable material. The conductive elements may include various passive and active elements, such as capacitors (e.g., metal-insulator-metal capacitor, MIMCAP), inductors, diodes, thin film transistors (TFT), metal-oxide-semiconductor field effect transistors (MOSFETs), complementary MOS (CMOS) transistors, bipolar junction transistors (BJTs), laterally diffused MOS (LDMOS) transistors, high-power MOS transistors, or another type of transistor. As shown in Fig. IE, the light-emitting element 104 is electrically connected to the circuit layer 120 through the conductive pads 106.

As shown in Fig. IF, a structure 200A is attached on top surfaces of the light-emitting elements 104 and the supporting structure 112, in accordance with some embodiments. The detail of the process for forming the structure 200A will be described later. In some embodiments, as shown in Fig. IF, the structure 200A includes a light blocking element 122, a red color conversion element 124, a green color conversion element 126 and a blue color conversion element 128. The red color conversion element 124, the green color conversion element 126, or the blue color conversion element 128 is also called as a wavelength conversion element in general. That is to say, in the present disclosure, the color conversion element is the same as the wavelength conversion element. The red color conversion element 124, the green color conversion element 126 and the blue color conversion element 128 are surrounded by the light blocking element 122, and are separated from each other by the light blocking element 122. In the present disclosure, the term "surround" can cover the "completely surround" and "partially surround" embodiments. Moreover, the red color conversion element 124, the green color conversion element 126 and the blue color conversion element 128 cover a portion of the top surfaces of the light-emitting elements 104. In some embodiments, the light blocking element 122 covers a portion of the top surfaces of the light-emitting elements 104, and cover a top surface of the supporting structure 112. Optionally, the scribe lines 116 are located under the light blocking element 122. The structure 200A may be attached to the light-emitting elements 104 by a transparent adhesive layer (not shown).

The light blocking element 122 can be used to shield the element or region which is not used to display colors in the light-emitting device 100A. For example, the light blocking element 122 may be used to shield the data lines and scan lines.

As shown in Fig. IF, the color conversion elements 124, 126 and 128 are over the light-emitting elements 104. In some embodiments, the red color conversion element 124, the green color conversion element 126 and the blue color conversion element 128 respectively correspond to a red pixel, a green pixel and a blue pixel. The material of the red color conversion element 124, the green color conversion element 126 and the blue color conversion element 128 include, but is not limited to, a quantum dot film, a fluorescent material, or another wavelength conversion material. For example, the color conversion elements 124, 126 and 128 are organic or inorganic layers blended with a quantum dot. The quantum dot may include, but is not limited to, zinc, cadmium, selenium, sulfur, InP, GaSb, GaAs, CdSe, CdS, ZnS or a combination thereof. The grain diameter of the quantum dot may range from about 1nm-30nm, but the present disclosure is not limited thereto.

When the quantum dots with different grain diameters are excited, the spectrum of light is altered and a different wavelength of light is emitted. For example, the excitation of the quantum dots with a smaller grain diameter results in emitting a shorter wavelength of light (such as blue light), and the excitation of the quantum dots with a greater grain diameter results in emitting a longer wavelength of light (such as red light). Therefore, by fine-tuning the grain diameter of the quantum dot, different wavelengths of light can be generated, and thereby a light-emitting device with a wide color gamut is achieved. For example, the red color conversion element 124 blended with a quantum dot having the first grain diameter may emit light of a red color after excitation. The green color conversion element 126 blended with a quantum dot having the second grain diameter may emit light of a green color after excitation. The blue color conversion element 128 blended with a quantum dot having the third grain diameter may emit light of a blue color after excitation.

In some embodiments, the refractive index (n1) of the light blocking element 122 is greater than the refractive index (n2) of the color conversion elements 124, 126 or 128. In addition, in some embodiments, the difference between the refractive index (n1) and the refractive index (n2) is greater than 1. For example, the difference between the refractive index of the light blocking element 122 and the refractive index of the red color conversion element 124 is greater than 1. The intensity $I_1$ of the light emitted from the light-emitting elements 104 and the intensity $I_2$ of the light reflected from the light blocking element 122 fit the following equation:

$$I_2 \propto I_1 * [(n1 - n2)^2/(n1 + n2)^2]$$

The equation implies that the intensity $I_2$ of the light is proportional to the difference between the refractive index (n1) and the refractive index (n2). That is, the greater the difference between the refractive index (n1) and the refractive index (n2) is, the greater the intensity $I_2$ is. In some cases, when the difference between the refractive index of the light blocking element 122 and the refractive index of the wavelength conversion element is greater than 1, the reflective light has greater intensity. As a result, the intensity of the emitting light of the light-emitting device is improved.

In some embodiments, the refractive index of the light blocking element 122 is greater than 2. For example, the material of the light blocking element 122 includes, but is not limited to, zirconium oxide ($ZrO_2$), potassium-sodium niobate ($KNbO_3$), silicon carbide (SiC), gallium phosphide (GaP), gallium arsenide (GaAs), zinc oxide (ZnO), silicon (Si), germanium (Ge), or silicon-germanium (SiGe). In some embodiments, the difference between the refractive index of the light blocking element 122 and the refractive index of the color conversion elements 124, 126 or 128 greater than 1 is measured in the wavelength of about 630nm. Since the light blocking element 122 may not be able to easily absorb longer wavelengths of light such as red light, a greater difference between the refractive index of the light blocking element 122 and the refractive index of the color conversion elements 124, 126 or 128 in the wavelength of about 630nm can assist in improving the efficiency of color conversion for red light.

In some embodiments, the light-emitting elements 104 emit blue light, and the blue color conversion element 128 of the blue pixel may be replaced by a transparent filler. In some embodiments, the light-emitting element 104 emits UV light, or other visible or invisible lights. In some embodiments, the extinction coefficient of the light blocking element 122 is greater than the extinction coefficient of the color conversion element 124, 126, or 128 measured in the wavelength of about 450nm. In some embodiments, the extinction coefficient of the supporting structure 112 is greater than the extinction coefficient of the light-emitting element 104 in the wavelength of about 450nm. In some embodiments, the extinction coefficient of the light blocking structure 122 is greater than the extinction coefficient of the light-emitting elements 104. When the extinction coefficient of the light blocking element 122 is greater than that of the light-emitting element 104 and than that of the wavelength conversion element 124, 126, or 128 in the wavelength of about 450nm, the blue light emitted from the light-emitting elements 104 may be absorbed more efficiently by the light blocking element 122 or the supporting structure 112. As a result, light leakage can be prevented or colorimetric purity of the light-emitting device is enhanced.

As shown in Fig. 1G, a light filter layer 130, a protective layer 132 and a cover layer 134 are disposed on the light blocking element 122, the color conversion elements 124, 126 and 128 sequentially in accordance with some embodiments. As a result, a light-emitting device 100A is created. The light filter layer 130 may allow specific wavelength of light to pass through. For example, the blue light filter layer allows wavelength of light between about 400nm and about 500nm to pass through, the green light filter layer allows wavelength of light between about 500nm and about 570nm to pass through, and the red light filter layer allows wavelength of light between about 620nm and about 750nm to pass through. In some embodiments, the light filter layer 130 is a red light filter layer disposed over the red color conversion element 124, a green light filter layer disposed over the green color conversion element 126, or a light filter layer capable of filtering blue light disposed over the red color conversion element 124 and the green color conversion element 126. Fig. 1G illustrates that the light filter layer 130 extends from the top surface of the red color conversion element 124 to the top surface of the green color conversion element 126 continually. Many variations and/or modifications can be made to embodiments of the disclosure. In some embodiments, the light filter layer 130 may cover the top surface of the red color conversion element 124 and cover the top surface of the green color conversion element 126. In some embodiments, the light filter layer 130 does not cover the top surface of the blue color conversion element 128. In some embodiments, the light filter layer 130 is a pigment filter made of organic films. In some embodiments, the light filter layer 130 is a multi-film stacked by silicon oxide film, silicon nitride film, titanium oxide film and other applicable films. In some embodiments, the light filter layer 130 covers a portion of the light blocking element 122 in order to prevent light leakage.

The protective layer 132 is configured to prevent the color conversion elements 124, 126 and 128 from damage due to the environment. As shown in Fig. 1G, the protective layer 132 covers the top surface of the light blocking element 122, the light filter layer 130 and the blue color conversion element 128, and covers the side surface of the light blocking element 122 and the light filter layer 130. In some embodiments, the protective layer 132 is in direct contact with the top surface of the blue color conversion element 128. In addition, the protective layer 132 can provide a plane surface for disposing the cover layer 134. The material of the protective layer 132 may include, but is not limited to, phosphosilicate glass (PSG), borophosphosilicate glass (BPSG), silicon oxide, silicon nitride, silicon oxynitride, or organic materials.

The cover layer 134 is used as the outer surface of the light-emitting device 100A. As shown in Fig. 1G, the cover layer 134 covers the top surface of the protective layer 132. The material of the cover layer 134 includes, but is not limited to, glass, quartz, poly(methyl methacrylate) (PMMA), polycarbonate (PC), polyimide (PI) or other applicable materials.

In some embodiments, the angle θ1 constituted by the top surface 104T of the light-emitting elements 104 and the side surface 122S of the light blocking element 122 is greater than the angle θ2 constituted by the top surface 122T of the light blocking element 122 and the side surface 130S of the light filter layer 130. In some embodiments, the angle θ2 is an acute angle. When the angle θ2 is smaller than 90°, it prevents peeling when the protective layer is formed. In some cases, the angle θ2 is not greater than the angle θ1. When the angle θ2 is smaller than angle θ1, it assists in the diffusion of light, or prevents the light from mixing with light from adjacent pixels. In addition, the angle θ1 may be an angle constituted by the bottom surface and the side surface of the color conversion elements 124, 126 and 128. The angle θ2 may be an angle constituted by the side surface of the light filter layer 130 and the interface between the light filter layer 130 and the light block element 122.

In some embodiments, the refractive index (n3) of the light-emitting elements 104 is greater than the refractive index (n2) of the color conversion element 124, 126, or 128, the refractive index (n2) of the color conversion element 124, 126, or 128 is greater than the refractive index (n4) of the light filter layer 130, and the refractive index (n4) of the light filter layer 130 is greater than the refractive index (n5) of the protective layer 132. In some embodiments, the difference between the refractive index of two adjacent mediums is smaller than 0.5. When the difference between the refractive index of two adjacent mediums is smaller than 0.5, the refracted light may have smaller angle of refraction. As a result, the light-emitting efficiency of the light-emitting device 100A is improved.

In some embodiments, the hardness of the light blocking element 122 is greater than that of the supporting structure 112. When the hardness of the light blocking element 122 is greater than that of the supporting structure 112, the stability is enhanced during assembly of the structure 200A and the light-emitting elements 104. In some embodiments, the flexibility of the light blocking element 122 is smaller than that of the supporting structure 112. When the flexibility of the light blocking element 122 is smaller than that of the supporting structure 112, the stability is enhanced during assembly of the structure 200A and the light-emitting elements 104.

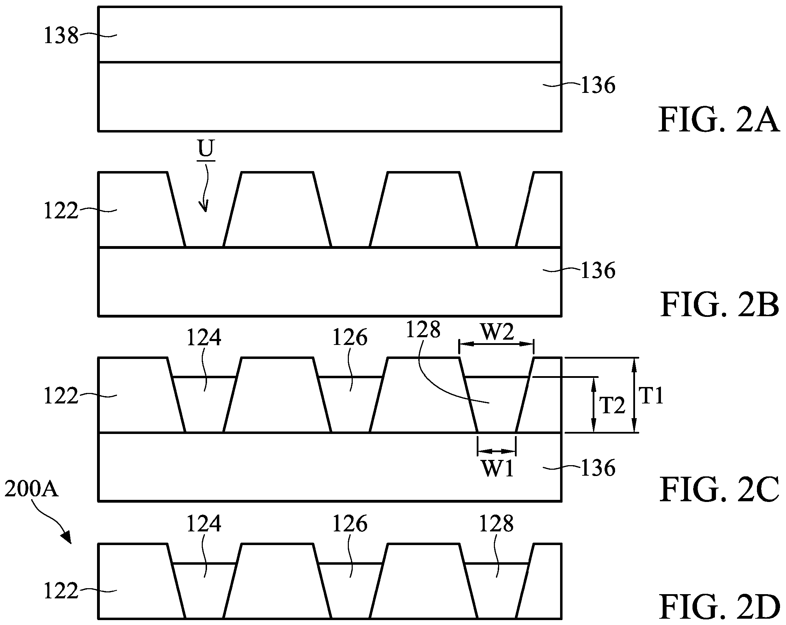

Figs. 2A-2D are cross-sectional views of various stages of a process for forming a structure 200A in accordance with some embodiments of the present disclosure which are not according to the claimed invention. As shown in Fig. 2A, a carrier substrate 136 is provided and a light blocking layer 138 is formed on the carrier substrate 136, in accordance with some embodiments. The carrier substrate 136 is used as a substrate for disposing subsequently formed element. The carrier substrate 136 may be a glass substrate, a ceramic substrate, a plastic substrate or another applicable substrate.

The light blocking layer 138 is a material for forming the light blocking element 122. The light blocking layer 138 may be formed by a deposition process or a crystal growth process. The deposition process includes, but is not limited to, chemical vapor deposition (CVD), sputtering, resistive thermal evaporation, electron beam evaporation, and any other applicable methods. The chemical vapor deposition may include, but is not limited to, low pressure chemical vapor deposition (LPCVD), low temperature chemical vapor deposition (LTCVD), rapid thermal chemical vapor deposition (RTCVD), plasma enhanced chemical vapor deposition (PECVD), atomic layer deposition (ALD), and any other applicable methods.

As shown in Fig. 2B, the light blocking layer 138 is patterned to form the light blocking element 122, in accordance with some embodiments. The light blocking layer 138 may be patterned by a photolithography process. The photolithography process includes, but is not limited to, photoresist coating (e.g., spin-on coating), soft baking, mask alignment, exposure, post-exposure baking, developing the photoresist, rinsing and drying (e.g., hard baking), dry etching, or wet etching. The photolithography process may also be implemented or replaced by another proper method such as maskless photolithography, electron-beam writing or ion-beam writing. After the light blocking element 122 is formed, a plurality of openings U surrounded by the light blocking element 122 are formed, and a portion of the top surface of the carrier substrate 136 is exposed.

As shown in Fig. 2C, the red color conversion element 124, the green color conversion element 126 and the blue color conversion element 128 are formed in the openings U, in accordance with some embodiments. In some embodiments, the material of the color conversion element is sprayed into the openings U by an inkjet or a printing process. In some embodiments, the light blocking element 122 has the thickness T1, and the color conversion element 124, 126 or 128 has the thickness T2. When the thickness T2 is smaller than the thickness T1, it prevents the material of different color conversion element from mixture. In some embodiments, the width W1 of the bottom surface of the color conversion element 124, 126 or 128 is smaller than the width W2 of the top surface of the color conversion element 124, 126 or 128. When the width W1 is smaller than the width W2, the light-emitting efficiency or the angle of the vision is improved.

As shown in Fig. 2D, the carrier substrate 136 is removed from the light blocking element 122, the red color conversion element 124, the green color conversion element 126 and the blue color conversion element 128, and the structure 200A is created, in accordance with some embodiments. In some embodiments, the carrier substrate 136 is removed by heating, irradiation or another applicable method.

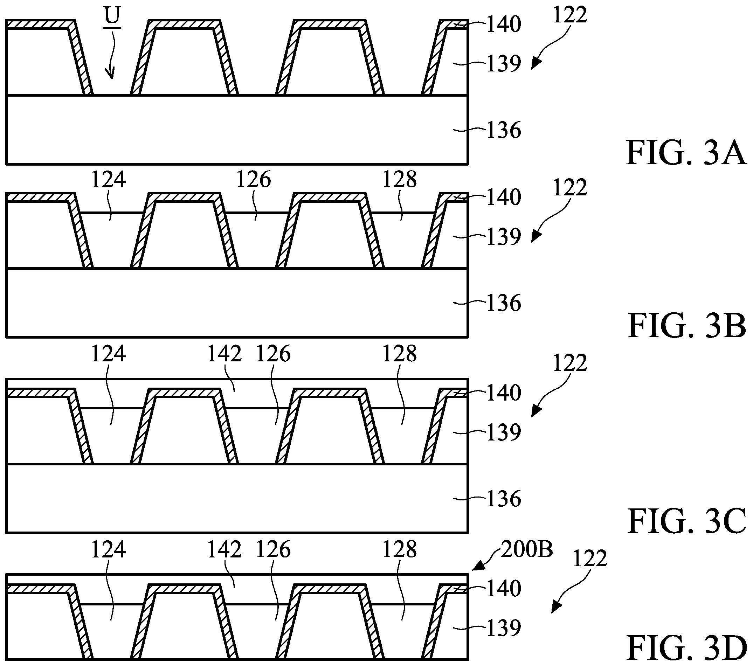

Figs. 2A-2D illustrate that the light blocking element 122 is made of a single component. Many variations and/or modifications can be made to embodiments of the disclosure. The light blocking element 122 may be a composite structure including two or more materials. Referring to Figs. 3A-3D, Figs. 3A-3D are cross-sectional views of various stages of a process for forming a structure 200B in accordance with the claimed invention. As shown in Fig. 3A, a patterned photoresist element 139 is formed on the carrier substrate 136, and a capping layer 140 is formed conformally over the photoresist element 139 in accordance with some embodiments. The photoresist element 139 and the capping layer 140 may be formed by a multiple deposition or a photolithography process. In some embodiments, the light blocking element 122 includes the photoresist element 139 and the capping layer 140 covering the photoresist element 139. The photoresist element 139 includes, but is not limited to, black photoresist.

In some embodiments, the top and side surfaces of the photoresist element 139 are covered by the capping layer 140. In this embodiment, the capping layer 140 includes silicon. More specially, the capping layer 140 is made of amorphous silicon or poly-silicon so that the light blocking element 122 has better light blocking or waterproofing ability. In some embodiments, the capping layer 140 includes high-k materials. The high-k materials may include, but is not limited to, metal oxide, metal nitride, metal silicide, transition metal oxide, transition metal nitride, transition metal silicide, transition metal oxynitride, metal aluminate, zirconium silicate, and zirconium aluminate. Examples of the material of the high-k material include, but are not limited to, LaO, AlO, ZrO, TiO, $Ta_2O_5$, $Y_2O_3$, $SrTiO_3$(STO), $BaTiO_3$(BTO), BaZrO, $HfO_2$, $HfO_3$, HfZrO, HfLaO, HfSiO, HfSiON, LaSiO, AlSiO, HfTaO, HfTiO, HfTaTiO, HfAlON, $(Ba,Sr)TiO_3$(BST), $Al_2O_3$, any other applicable high-k material, and combinations thereof.

As shown in Fig. 3B, the red color conversion element 124, the green color conversion element 126 and the blue color conversion element 128 are formed in the openings U, in accordance with some embodiments. In some embodiments, the materials of the color conversion elements 124, 126 and 128 are sprayed into the openings U by an inkjet or a printing process.

As shown in Fig. 3C, a planar layer 142 is formed over the color conversion elements 124, 126, 128 and the capping layer 140, in accordance with some embodiments. The outer surface of the planar layer 142 may be used to attach the light-emitting elements 104 for subsequent attaching process. In some embodiments, the planar layer 142 includes, but is not limited to, organic material or inorganic material such as silicon oxide, silicon nitride, silicon oxynitride, and other dielectric materials. As shown in Fig. 3C, the top and side surfaces of the color conversion elements 124, 126 and 128 are covered by the planar layer 142. As a result, it prevents the color conversion elements 124, 126 and 128 from being damaged due to subsequent processes.

As shown in Fig. 3D, the carrier substrate 136 is removed from the light blocking element 122, the red color conversion element 124, the green color conversion element 126 and the blue color conversion element 128, and the structure 200B is created in accordance with some embodiments. In some embodiments, the carrier substrate 136 is removed by heating, irradiation, or another applicable method.

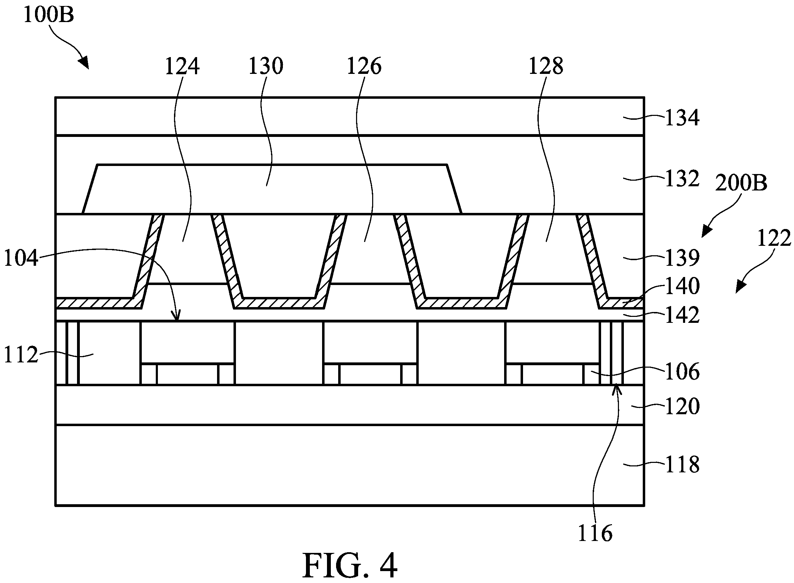

Referring to Fig. 4, Fig. 4 is a cross-sectional view of a light-emitting device 100B in accordance with the claimed invention. One of the differences between the light-emitting device 100A shown in Fig. 1G and the light-emitting device 100B shown in Fig. 4 is that the structure 200A in the light-emitting device 100A is replaced with the structure 200B. In some embodiments, the planar layer 142 is disposed between the light-emitting elements 104 and the light blocking element 122. As shown in Fig. 4, the planar layer 142 covers the top surfaces of the light-emitting elements 104 and the supporting structure 112. In addition, a portion of the capping layer 140 is not covered by the light filter layer 130. The light-emitting device 100B with the structure 200B may have better light blocking or waterproof ability.

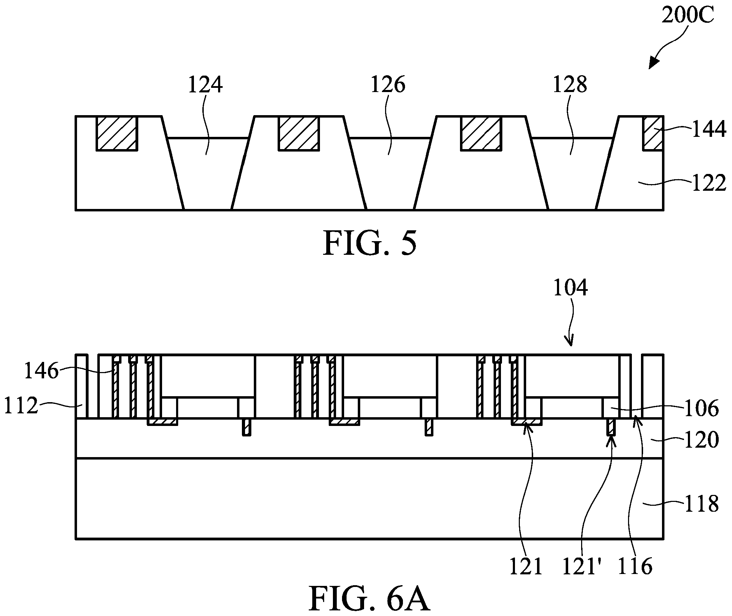

Many variations and/or modifications can be made to embodiments of the disclosure. Referring to Fig. 5, Fig. 5 is a cross-sectional view of a structure 200C in accordance with some embodiments of the present disclosure which are not according to the claimed invention; As shown in Fig. 5, an active element 144 is formed in the light blocking element 122, in accordance with some embodiments. In some embodiments, the active element 144 includes a thin film transistor such as a switch transistor, a driver, a reset transistor, or another active element.

Fig. 5 illustrates the active element 144 is embedded in the light blocking element 122. Many variations and/or modifications can be made to embodiments of the disclosure. In some embodiments, a portion of the active element 144 is formed over the light blocking element 122. In some embodiments, the active element 144 is formed over the surface of the light blocking element 122. Multiple processes may be performed on the light blocking element 122 to form the active element 144. Alternatively, the active element 144 may be formed on another substrate (not shown), and next be transferred to the surface of the light blocking element 122.

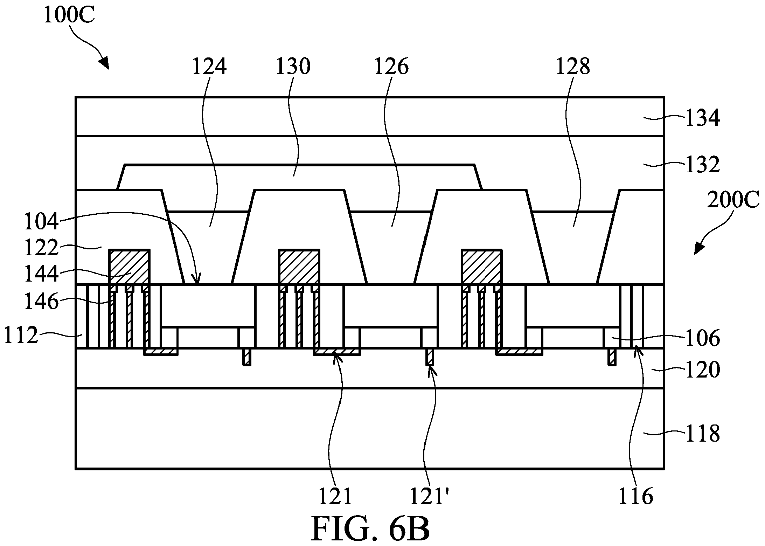

Referring to Figs. 6A and 6B, Figs. 6A and 6B are cross-sectional views of two stages of a process for forming a light-emitting device 100C in accordance with some embodiments of the present disclosure which are not according to the claimed invention. The materials and processing steps to arrive at the intermediate structure illustrated in Fig. 6A may be similar to the previously described embodiment in Fig. 1A through IE, and thus, the description is not repeated herein. The details of this embodiment that are similar to those of the previously described embodiment will not be repeated herein.

As shown in Fig. 6A, a wire 146 is formed in the supporting structure 112, in accordance with some embodiments. The wire 146 is electrically connected to the light-emitting elements 104 through wires 121 and 121' which are formed in the circuit layer 120. The material of the wire 146 may include, but is not limited to, copper (Cu), aluminum (Al), molybdenum (Mo), tungsten (W), gold (Au), chromium (Cr), nickel (Ni), platinum (Pt), titanium (Ti), an alloy of the above, a combination of the above, or any other applicable material. In some embodiments, a photolithography process is performed so that the openings are formed in the supporting structure 112, and a portion of the circuit layer 120 is exposed. Next, the conductive material is filled into the openings. It is appreciated that the wire 146 may be formed before the light-emitting elements 104 are attached to the substrate 118.

It should be noted that the wire 146 shown in Fig. 6A is merely an example for better understanding the concept of the disclosure, and the scope of disclosure is not intended to be limiting. That is, the wire 146 may be arranged in various ways in various embodiments.

The wires 121 and 121' are formed in the circuit layer 120, and in contact with the conductive pads 106. The material of the wires 121 and 121' may include, but is not limited to, copper (Cu), aluminum (Al), molybdenum (Mo), tungsten (W), gold (Au), chromium (Cr), nickel (Ni), platinum (Pt), titanium (Ti), an alloy of the above, a combination of the above, or any other applicable material.

As shown in Fig. 6B, the structure 200C is attached to the light-emitting elements 104, in accordance with some embodiments. Next, the light filter layer 130, the protective layer 132 and the cover layer 134 are formed sequentially over the structure 200C, and the light-emitting device 100C is created. As shown in Fig. 6B, the active element 144 is electrically connected to the light-emitting elements 104 through the wire 146, the wires 121, 121' and the conductive pads 106. In addition, the active element 144 is electrically connected to the active elements and/or the passive elements formed in circuit layer 120. The wires 146 are respectively electrically connected to a source electrode, a drain electrode and a gate electrode (not shown) of the active element 144. In this embodiment, some active elements (such as the switch transistor, the driver, the reset transistor) are formed in the light blocking element 122 rather than circuit layer 120. Therefore, the thickness may be decreased so that the size of the light-emitting device 100C is reduced since the circuit layer 120 is thinner. In other embodiments, a passive element is electrically connected to the light-emitting element 104.

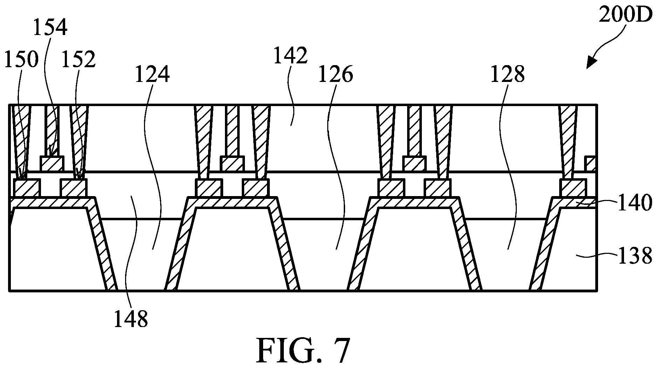

Many variations and/or modifications can be made to embodiments of the disclosure. Referring to Fig. 7, Fig. 7 is a cross-sectional view of a structure 200D in accordance with the claimed invention. One of the differences between the structure 200D shown in Fig. 7 and the structure 200C shown in Fig. 3D is that the structure 200D further includes conductive elements electrically connected to the capping layer 140.

As shown in Fig. 7, the structure 200D includes a source electrode 150, a drain electrode 152 and a gate electrode 154 over the capping layer 140, in accordance with some embodiments. At first, a source electrode 150 and a drain electrode 152 are formed on the capping layer 140. Then, a gate insulating layer 148 is formed before the formation of the planar layer 142. In some embodiments, the gate insulating layer 148 is made of silicon oxide or another dielectric material. Next, a conductive material is deposited on the gate insulating layer 148 and then patterned to form the gate electrode 154. The material of the gate electrode 154 may include metal or another conductive material. After the gate electrode 154 is formed, the planar layer 142 is deposited over the gate electrode 154 and the gate insulating layer 148. Next, a photolithography process is performed so that the openings are formed in the planar layer 142 and the gate insulating layer 148, and a portion of the surface of the source electrode 150, the drain electrode 152, and the gate electrode 154 is exposed. Next, the conductive material is filled into the openings to contact the source electrode 150, the drain electrode 152, and the gate electrode 154. The material of the source electrode 150, the drain electrode 152, and the gate electrode 154 may include, but is not limited to, copper, aluminum, tungsten, gold, chromium, nickel, platinum, titanium, iridium, rhodium, an alloy of the above, a combination of the above, or any other applicable conductive material.

As shown in Fig. 7, the capping layer 140 is in contact with the source electrode 150 and the drain electrode 152. Moreover, the gate electrode 154 is separated from the capping layer 140 by the gate insulating layer 148. In some embodiments, the capping layer 140 is made of amorphous silicon, poly-silicon, or metal oxide semiconductor. Therefore, the capping layer 140 may be electrically connected to the source electrode 150 and the drain electrode 152. As a result, the structure 200D may be used as a switch to control the light-emitting device. In some embodiments, the structure 200C of the light-emitting device 100C is replaced by the structure 200D shown in Fig. 7 in an upside down manner, such that the wires 146 are electrically connected to the source electrode 150, the drain electrode 152, and the gate electrode 154 through the conductive material filled in the openings respectively.

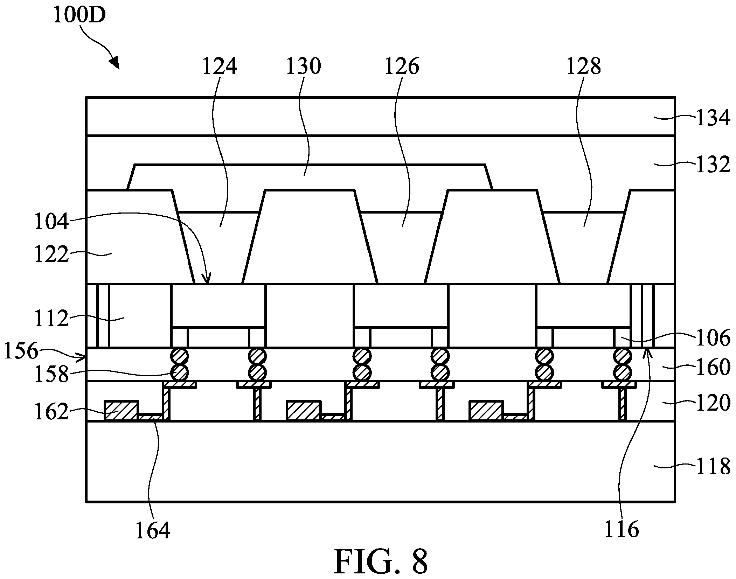

Many variations and/or modifications can be made to embodiments of the disclosure. Fig. 8 is a cross-sectional view of a light-emitting device 100D in accordance with some embodiments of the present disclosure which are not according to the claimed invention. One of the differences between the light-emitting device 100D shown in Fig. 8 and the light-emitting device 100A shown in Fig. 1G is that the light-emitting device 100D further includes a conductive film 156 disposed between the light-emitting elements 104 and the circuit layer 120.

As shown in Fig. 8, an active element 162 and a wire 164 are formed in the circuit layer 120. The circuit layer 120 is disposed on the substrate 118. Thus, the active element 162 is disposed on the substrate 118. The active element 162 may include a thin film transistor such as a switch transistor, a driver, a reset transistor, or another active element. The material of the wire 164 may be similar to or the same as that of the wire 146, and is not repeated herein. In some embodiments, the conductive film 156 is an anisotropic conductive film (ACF) which includes a plurality of conductive particles 158 and an adhesive layer 160. The conductive particle 158 may include metal or another conductive material. The adhesive layer 160 may include optical adhesive (OCA), optical clear resin (OCR), or another suitable material. As shown in Fig. 8, the conductive particles 158 are arranged vertically. Since the adhesive layer 160 is made of insulation material, the conductive film 156 only provides a vertical electrically conductive path. As shown in Fig. 8, the light-emitting elements 104 are electrically connected to the active element 162 through the conductive pads 106, the conductive particle 158 and the wire 164. The use of the conductive film 156 assists in the mass production of light-emitting devices 100D.

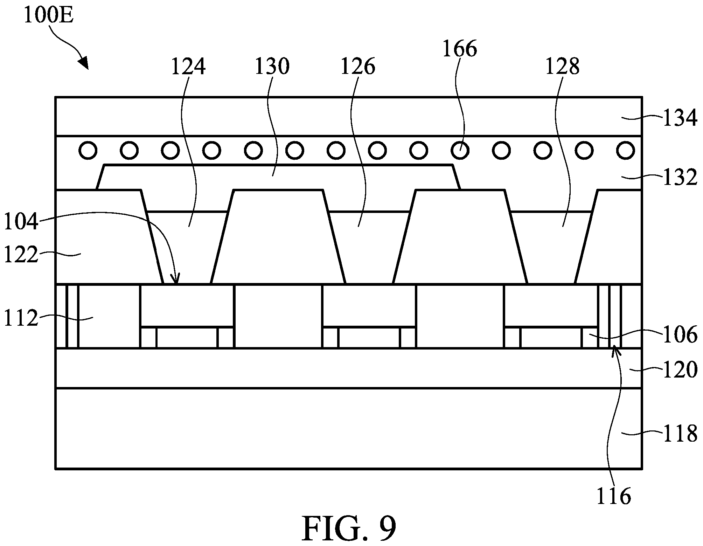

Many variations and/or modifications can be made to embodiments of the disclosure. Fig. 9 is a cross-sectional view of a light-emitting device 100E in accordance with some embodiments of the present disclosure which are not according to the claimed invention. One of the differences between the light-emitting device 100E shown in Fig. 9 and the light-emitting device 100A shown in Fig. 1G is that a plurality of scattering particles 166 are formed in the protective layer 132.

The material of the scattering particle 166 includes, but is not limited to, titanium dioxide (TiO2), alumina trioxide (Al2O3), zirconium dioxide (ZrO2), silicon dioxide (SiO2), tantalum pentoxide (Ta2O5), tungsten oxide (WO3), yttrium oxide (Y2O3), cerium dioxide (CeO2), antimony trioxide (Sb2O3), niobium dioxide (Nb2O2), boron trioxide (B2O3), zinc oxide (ZnO), indium trioxide (In2O3), cerium trifluoride (CeF3), magnesium difluoride (MgF2), calcium difluoride (CaF2), a combination thereof, or another suitable nanoparticle. The formation of the scattering particle 166 in the protective layer 132 can assist in forming a light-emitting device 100E with uniform light-extraction.

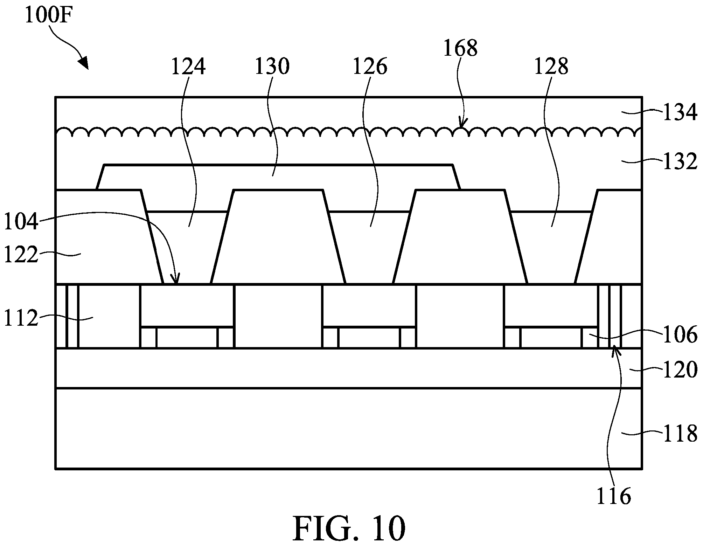

Many variations and/or modifications can be made to embodiments of the disclosure. Fig. 10 is a cross-sectional view of a light-emitting device 100F in accordance with some embodiments of the present disclosure which are not according to the claimed invention. One of the differences between the light-emitting device 100F shown in Fig. 10 and the light-emitting device 100A shown in Fig. 1G is that a microstructure 168 is formed on the top surface of the protective layer 132.

In some embodiments, the microstructure 168 may be a rough surface formed on the protective layer 132. In this embodiment, the microstructure 168 is formed by performing an etching process or a mechanical abrasion on the top surface of the protective layer 132. In some embodiments, the microstructure 168 includes multiple micro lenses. The formation of the microstructure 168 can assist in forming a light-emitting device 100G with a greater angle of scattering light.

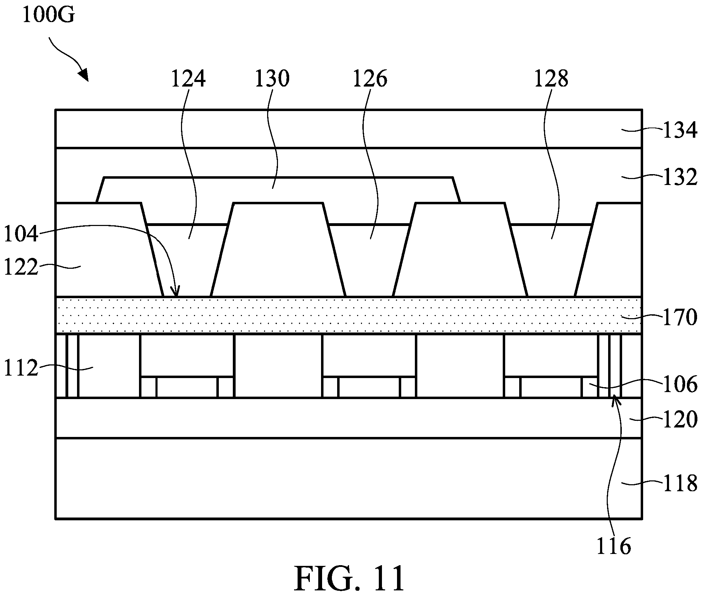

Many variations and/or modifications can be made to embodiments of the disclosure. Fig. 11 is a cross-sectional view of a light-emitting device 100G in accordance with some embodiments of the present disclosure which are not according to the claimed invention. One of the differences between the light-emitting device 100G shown in Fig. 11 and the light-emitting device 100A shown in Fig. 1G is that the light-emitting device 100G further includes a transflective layer 170 formed between the light-emitting elements 104 and the color conversion elements 124, 126 and 128.

In some embodiments, the transflective layer 170 is a distributed Bragg reflector (DBR) structure. The transflective layer 170 may include at least two materials with different refractive index. For example, the transflective layer 170 may include a plurality of silicon oxide films and a plurality of silicon nitride films. These silicon oxide films and silicon nitride films are arranged alternatively. In some embodiments, the material of the transflective layer 170 also includes silicon oxynitride or another dielectric material. The formation of the transflective layer 170 can assist in improving the light-emitting efficiency of the light-emitting device 100G.

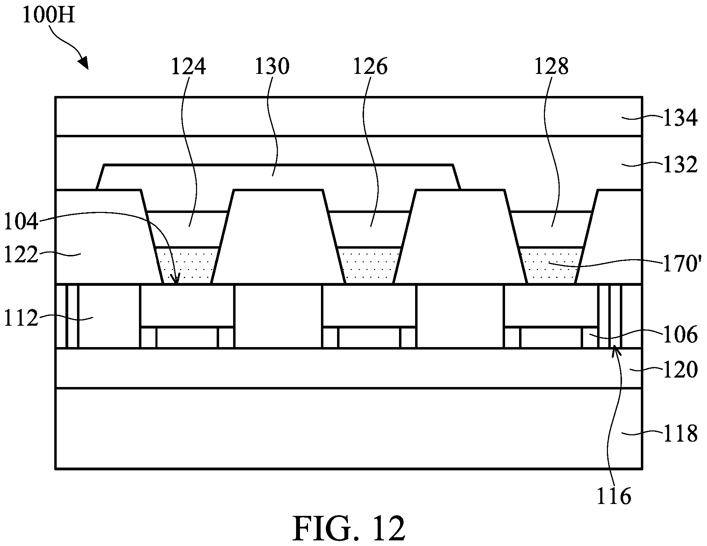

Many variations and/or modifications can be made to embodiments of the disclosure. Referring to Fig. 12, Fig. 12 is a cross-sectional view of a light-emitting device 100H in accordance with some embodiments of the present disclosure which are not according to the claimed invention. One of the differences between the light-emitting device 100H shown in Fig. 12 and the light-emitting device 100G shown in Fig. 11 is that the transflective layer 170' is surrounded by the light blocking element 122. The formation of the transflective layer 170' can assist in reducing the size of the light-emitting device 100H.

Although some embodiments according to the claimed invention and their advantages have been described in detail, it should be understood that various changes, substitutions and alterations can be made herein without departing from the scope of the invention as defined by the appended claims. For example, it will be readily understood by those skilled in the art that many of the features, functions, processes, and materials described herein may be varied while remaining within the scope of the present invention. Moreover, the scope of the present invention is not intended to be limited to the particular embodiments of the process, machine, manufacture, composition of matter, means, methods and steps described in the specification. As one of ordinary skill in the art will readily appreciate from the disclosure of the present invention, processes, machines, manufacture, compositions of matter, means, methods, or steps, presently existing or later to be developed, that perform substantially the same function or achieve substantially the same result as the corresponding embodiments described herein may be utilized according to the present invention. The scope of the invention is defined by the claims.

## Claims

1. A light-emitting device (100A), comprising:

a light-emitting element (104);
a wavelength conversion element (124) disposed on the light-emitting element, the wavelength conversion element having a first refractive index in a first wavelength; and
a light blocking element (122) surrounding and in direct contact with the wavelength conversion element, the light blocking element having a second refractive index in the first wavelength;
wherein the second refractive index is greater than the first refractive index, **characterized in that** the light blocking element (122) comprises a photoresist element (139) and a capping layer (140) covering the photoresist element.

2. The light-emitting device as claimed in claim 1, wherein a difference between the second refractive index and the first refractive index is greater than 1.

3. The light-emitting device as claimed in claim 1 or 2, wherein the first refractive index and the second refractive index are respectively measured in the first wavelength of 630nm.

4. The light-emitting device as claimed in one of the preceding claims, wherein an extinction coefficient of the wavelength conversion element (124) in a second wavelength is less than an extinction coefficient of the light blocking element (122) in the second wavelength.

5. The light-emitting device as claimed in claim 4, wherein the extinction coefficient of the wavelength conversion element (124) and the extinction coefficient of the light blocking element (122) are respectively measured in the second wavelength of 450nm.

6. The light-emitting device as claimed in claim 4 or 5, further comprising:
a supporting structure surrounding (112) the light-emitting element, wherein an extinction coefficient of the supporting structure in the second wavelength is greater than the extinction coefficient of the wavelength conversion element in the second wavelength.

7. The light-emitting device as claimed in one of the preceding claims, wherein a width of a bottom surface of the wavelength conversion element is less than a width of a top surface of the wavelength conversion element.

8. The light-emitting device as claimed in one of the preceding claims, wherein a thickness of the wavelength conversion element is less than a thickness of the light blocking element.

9. The light-emitting device as claimed in one of the preceding claims, further comprising:
an active element (144) electrically connected to the light-emitting element, in particular the active element (144) being formed in the light blocking element.

10. The light-emitting device as claimed in claim 9, further comprising:
a substrate attached to the light-emitting element, wherein the active element is disposed on the substrate.

11. The light-emitting device as claimed in one of the preceding claims, wherein the capping layer (140) comprises silicon.

12. The light-emitting device as claimed in one of the preceding claims, further comprising:

    a light filter layer (130) disposed on the wavelength conversion element; and
    a protective layer disposed on the light filter layer.

13. The light-emitting device as claimed in claim 12, wherein the light filter layer (130) has a third refractive index in the first wavelength, the protective layer has a fourth refractive index in the first wavelength, and the fourth refractive index is less than the third refractive index.

14. The light-emitting device as claimed in claim 12 or 13, further comprising:
a plurality of scattering particles (166) formed in the protective layer, in particular the protective layer comprising a microstructure (168) on a top surface of the protective layer.

15. The light-emitting device as claimed in one of the claims 12-14, wherein a first angle is constituted by a top surface of the light-emitting element and a side surface of the light blocking element, a second angle is constituted by a top surface of the light blocking element and a side surface of the light filter layer, and the second angle is less than the first angle.

16. The light-emitting device as claimed in one of the preceding claims, further comprising:
a transflective layer (170) disposed between the wavelength conversion element and the light-emitting element, in particular the transflective layer being a distributed Bragg reflector (DBR) structure.

**Patentansprüche**

1. Lichtemittierende Vorrichtung (100A), umfassend:

ein lichtemittierendes Element (104);
ein Wellenlängen-Umwandlungselement (124), das auf dem lichtemittierenden Element angeordnet ist, wobei das Wellenlängen-Umwandlungselement einen ersten Brechungsindex bei einer ersten Wellenlänge aufweist; und
ein lichtblockierendes Element (122), das das Wellenlängen-Umwandlungselement umgibt und in direktem Kontakt mit diesem steht, wobei das lichtblockierende Element einen zweiten Brechungsindex bei der ersten Wellenlänge aufweist;
wobei der zweite Brechungsindex größer ist als der erste Brechungsindex,
**dadurch gekennzeichnet, dass** das lichtblockierende Element (122) ein Photoresist-Element (139) und eine Abdeckschicht (140) aufweist, die das Photoresist-Element bedeckt.

2. Lichtemittierende Vorrichtung nach Anspruch 1, wobei eine Differenz zwischen dem zweiten Brechungsindex und dem ersten Brechungsindex größer als 1 ist.

3. Lichtemittierende Vorrichtung nach Anspruch 1 oder 2, wobei der erste Brechungsindex und der zweite Brechungsindex jeweils bei der ersten Wellenlänge von 630 nm gemessen werden.

4. Lichtemittierende Vorrichtung nach einem der vorhergehenden Ansprüche, wobei ein Extinktionskoeffizient des Wellenlängen-Umwandlungselements (124) bei einer zweiten Wellenlänge kleiner ist als ein Extinktionskoeffizient des lichtblockierenden Elements (122) bei der zweiten Wellenlänge.

5. Lichtemittierende Vorrichtung nach Anspruch 4, wobei der Extinktionskoeffizient des Wellenlängen-Umwandlungselements (124) und der Extinktionskoeffizient des lichtblockierenden Elements (122) jeweils bei der zweiten Wellenlänge von 450 nm gemessen werden.

6. Lichtemittierende Vorrichtung nach Anspruch 4 oder 5, ferner umfassend:
eine Stützstruktur, die das lichtemittierende Element umgibt (112), wobei ein Extinktionskoeffizient der Stützstruktur bei der zweiten Wellenlänge größer ist als der Extinktionskoeffizient des Wellenlängen-Umwandlungselements bei der zweiten Wellenlänge.

7. Lichtemittierende Vorrichtung nach einem der vorhergehenden Ansprüche, wobei eine Breite einer unteren Oberfläche des Wellenlängen-Umwandlungselements geringer ist als eine Breite einer oberen Oberfläche des Wellenlängen-Umwandlungselements.

8. Lichtemittierende Vorrichtung nach einem der vorhergehenden Ansprüche, wobei die Dicke des Wellenlängen-Umwandlungselements geringer ist als die Dicke des lichtblockierenden Elements.

9. Lichtemittierende Vorrichtung nach einem der vorangehenden Ansprüche, ferner umfassend:
ein aktives Element (144), das mit dem lichtemittierenden Element elektrisch verbunden ist, wobei insbesondere das aktive Element (144) in dem lichtblockierenden Element ausgebildet ist.

10. Lichtemittierende Vorrichtung nach Anspruch 9, ferner umfassend:
ein an dem lichtemittierenden Element befestigtes Substrat, wobei das aktive Element auf dem Substrat angeordnet ist.

11. Lichtemittierende Vorrichtung nach einem der vorhergehenden Ansprüche, wobei die Abdeckschicht (140) Silizium umfasst.

12. Lichtemittierende Vorrichtung nach einem der vorangehenden Ansprüche, ferner umfassend:

eine Lichtfilterschicht (130), die auf dem Wellenlängen-Umwandlungselement angeordnet ist; und
eine Schutzschicht, die auf der Lichtfilterschicht angeordnet ist.

13. Lichtemittierende Vorrichtung nach Anspruch 12, wobei die Lichtfilterschicht (130) einen dritten Brechungsindex bei der ersten Wellenlänge aufweist, die Schutzschicht einen vierten Brechungsindex bei der ersten Wellenlänge aufweist und der vierte Brechungsindex kleiner als der dritte Brechungsindex ist.

14. Lichtemittierende Vorrichtung nach Anspruch 12 oder 13, ferner umfassend:
eine Vielzahl von streuenden Partikeln (166), die in der Schutzschicht ausgebildet sind, wobei die Schutzschicht insbesondere eine Mikrostruktur (168) auf einer oberen Oberfläche der Schutzschicht aufweist.

15. Lichtemittierende Vorrichtung nach einem der Ansprüche 12 bis 14, wobei ein erster Winkel durch eine Oberfläche des lichtemittierenden Elements und eine Seitenfläche des lichtblockierenden Elements gebildet wird, wobei ein zweiter Winkel durch eine Oberfläche des lichtblockierenden Elements und eine Seitenfläche der Lichtfilterschicht gebildet wird und der zweite Winkel kleiner als der erste Winkel ist.

16. Lichtemittierende Vorrichtung nach einem der vorhergehenden Ansprüche, ferner umfassend:
eine transflektive Schicht (170), die zwischen dem Wellenlängen-Umwandlungselement und dem lichtemittierenden Element angeordnet ist, wobei die transflektive Schicht insbesondere eine verteilte Bragg-Reflektorstruktur (DBR) ist.

**Revendications**

1. Dispositif électroluminescent (100A) comprenant:

un élément émetteur de lumière (104);
un élément de conversion de longueur d'onde (124) disposé sur l'élément émetteur de lumière, l'élément de conversion de longueur d'onde ayant un premier indice de réfraction à une première longueur d'onde; et
un élément de blocage de la lumière (122) entourant l'élément de conversion de longueur d'onde et en contact direct avec celui-ci, l'élément de blocage de la lumière ayant un deuxième indice de réfraction à la première longueur d'onde;
dans lequel le deuxième indice de réfraction est supérieur au premier indice de réfraction, **caractérisé en ce que** l'élément de blocage de la lumière (122) comprend un élément photorésistant (139) et une couche de couverture (140) qui recouvre l'élément photorésistant.

2. Dispositif électroluminescent selon la revendication 1, dans lequel une différence entre le deuxième indice de réfraction et le premier indice de réfraction est supérieure à 1.

3. Dispositif électroluminescent selon la revendication 1 ou 2, dans lequel le premier indice de réfraction et le deuxième indice de réfraction sont chacun mesurés à la première longueur d'onde de 630 nm.

4. Dispositif électroluminescent selon l'une quelconque des revendications précédentes, dans lequel un coefficient d'extinction de l'élément de conversion de longueur d'onde (124) à une deuxième longueur d'onde est inférieur à un coefficient d'extinction de l'élément de blocage de lumière (122) à la deuxième longueur d'onde.

5. Dispositif électroluminescent selon la revendication 4, dans lequel le coefficient d'extinction de l'élément de conversion de longueur d'onde (124) et le coefficient d'extinction de l'élément de blocage de lumière (122) sont mesurés respectivement à la deuxième longueur d'onde de 450 nm.

6. Dispositif électroluminescent selon la revendication 4 ou 5, comprenant en outre:

une structure de support entourant l'élément émetteur de lumière (112), dans laquelle un coefficient d'extinction de la structure de support à la deuxième longueur d'onde est supérieur au coefficient d'extinction de l'élément de conversion de longueur d'onde à la deuxième longueur d'onde.

**7.** Dispositif électroluminescent selon l'une quelconque des revendications précédentes, dans lequel une largeur d'une surface inférieure de l'élément de conversion de longueur d'onde est inférieure à une largeur d'une surface supérieure de l'élément de conversion de longueur d'onde.

**8.** Dispositif électroluminescent selon l'une quelconque des revendications précédentes, dans lequel l'épaisseur de l'élément de conversion de longueur d'onde est inférieure à l'épaisseur de l'élément de blocage de la lumière.

**9.** Dispositif électroluminescent selon l'une quelconque des revendications précédentes, comprenant en outre:
un élément actif (144) connecté électriquement à l'élément émetteur de lumière, dans lequel, en particulier, l'élément actif (144) est formé dans l'élément de blocage de la lumière.

**10.** Dispositif électroluminescent selon la revendication 9, comprenant en outre:
un substrat fixé à l'élément émetteur de lumière, l'élément actif étant disposé sur le substrat.

**11.** Dispositif électroluminescent selon l'une quelconque des revendications précédentes, dans lequel la couche de couverture (140) comprend du silicium.

**12.** Dispositif électroluminescent selon l'une quelconque des revendications précédentes, comprenant en outre:

une couche de filtrage de la lumière (130) disposée sur l'élément de conversion de longueur d'onde; et
une couche de protection disposée sur la couche de filtrage de la lumière.

**13.** Dispositif électroluminescent selon la revendication 12, dans lequel la couche de filtre de lumière (130) a un troisième indice de réfraction à la première longueur d'onde, la couche de protection a un quatrième indice de réfraction à la première longueur d'onde, et le quatrième indice de réfraction est inférieur au troisième indice de réfraction.

**14.** Dispositif électroluminescent selon la revendication 12 ou 13, comprenant en outre:
une pluralité de particules diffusantes (166) formées dans la couche protectrice, la couche protectrice ayant en particulier une microstructure (168) sur une surface supérieure de la couche protectrice.

**15.** Dispositif électroluminescent selon l'une quelconque des revendications 12 à 14, dans lequel un premier angle est formé par une surface de l'élément émetteur de lumière et une surface latérale de l'élément de blocage de lumière, dans lequel un deuxième angle est formé par une surface de l'élément de blocage de lumière et une surface latérale de la couche de filtrage de lumière, et dans lequel le deuxième angle est inférieur au premier angle.

**16.** Dispositif électroluminescent selon l'une quelconque des revendications précédentes, comprenant en outre:
une couche transflective (170) disposée entre l'élément de conversion de longueur d'onde et l'élément émetteur de lumière, la couche transflective étant en particulier une structure de réflecteur de Bragg distribué (DBR).

104

102

106

## FIG. 1A

104

106

110

108

## FIG. 1B

112
106
110

108

## FIG. 1C

EP 3 605 623 B1

EP 3 605 623 B1

FIG. 1D

FIG. 1E

FIG. 1F

$$200A \begin{cases} 124 \\ 126 \\ 128 \\ 122 \end{cases}$$

FIG. 1G

138 ─  
─ 136

FIG. 2A

U

122 ─  
─ 136

FIG. 2B

124    126    128    W2

122 ─  
T2  T1

W1    ─ 136

FIG. 2C

200A

124    126    128

122 ─

FIG. 2D

EP 3 605 623 B1

FIG. 3A

FIG. 3B

FIG. 3C

FIG. 3D

EP 3 605 623 B1

FIG. 4

EP 3 605 623 B1

200C

124    126    128

144

122

## FIG. 5

104

146

112

106

120

118

121    121'    116

## FIG. 6A

FIG. 6B

EP 3 605 623 B1

EP 3 605 623 B1

FIG. 7

FIG. 8

FIG. 9

FIG. 10

EP 3 605 623 B1

EP 3 605 623 B1

100G

124    130    126         128

134

132

104

122

170

112

106

120

118

116

FIG. 11

FIG. 12

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 102016106841 B3
- US 2017358604 A1

- WO 2008018615 A1